# EUROPEAN PATENT APPLICATION

(11) **EP 2 219 237 A2**
(43) Date of publication of application: **18.08.2010**
(21) Application number: 10153867.6
(22) Date of filing: 17.02.2010
(51) Int. Cl.: H01L 33/22, H01L 33/42

(54) **Semiconductor light emitting device and method of manufacturing the same**

(30) Priority: 17.02.2009 KR 20090013173
(71) Applicant: LG Innotek Co., Ltd., Seoul 150-721 (KR)
(72) Inventor: Kim, Sung Kyoon, 506-816, Gwangju (KR)
(74) Representative: Cabinet Plasseraud

(57) **Abstract**

Disclosed is a semiconductor light emitting device (100). The semiconductor light emitting device includes a first conductive semiconductor layer (120); an active layer on the first conductive semiconductor layer (130); and a second conductive semiconductor layer (140) on the active layer, in which a patterned roughness (145) is formed on a top surface of the second conductive semiconductor layer.

## Description

The embodiment relates to a semiconductor light emitting device and a method of manufacturing the same.

Groups III-V nitride semiconductors have been extensively used as main materials for light emitting devices, such as a light emitting diode (LED) or a laser diode (LD), due to the physical and chemical characteristics thereof.

In general, the groups III-V nitride semiconductors include a semiconductor material having a compositional formula of InₓAl_{y}Ga_{1-x-y}N (0≤x≤1, 0 ≤y≤1, and 0≤x+y≤1). The LED or LD using the nitride semiconductor material is mainly used for the light emitting device to provide the light. For instance, the LED or the LD is used as a light source for various products, such as a keypad light emitting part of a cellular phone, an electric signboard, and an illumination device.

The embodiment provides a semiconductor light emitting device and a method of manufacturing the same, capable of improving light extracting efficiency.

The semiconductor light emitting device according to the embodiment includes a first conductive semiconductor layer; an active layer on the first conductive semiconductor layer; and a second conductive semiconductor layer on the active layer, in which a patterned roughness is formed on a top surface of the second conductive semiconductor layer.

The method of manufacturing a semiconductor light emitting device according to the embodiment includes depositing a first conductive semiconductor layer, an active layer and a second conductive semiconductor layer; forming a metal layer on the second conductive semiconductor layer; forming a metal dot layer by heat treatment to the metal layer; and etching the metal dot layer and the second conductive semiconductor layer to form a patterned roughness having a nano-size on a surface of the second conductive semiconductor layer.

The embodiment can improve light extracting efficiency.
FIG. 1 is a sectional view showing a semiconductor light emitting device according to the first embodiment;
FIGS. 2 to 6 are views showing the procedure for manufacturing a semiconductor light emitting device according to the first embodiment; and
FIG. 7 is a sectional view showing a semiconductor light emitting device according to the second embodiment.

In the description of the embodiments, it will be understood that, when a layer (or film), a region, a pattern, or a structure is referred to as being "on" or "under" another substrate, another layer (or film), another region, another pad, or another pattern, it can be "directly" or "indirectly" on the other substrate, layer (or film), region, pad, or pattern, or one or more intervening layers may also be present. Such a position of the layer has been described with reference to the drawings.

The thickness and size of each layer shown in the drawings can be exaggerated, omitted or schematically drawn for the purpose of convenience or clarity. In addition, the size of elements does not utterly reflect an actual size.

Hereinafter, the embodiments will be described with reference to the accompanying drawings.

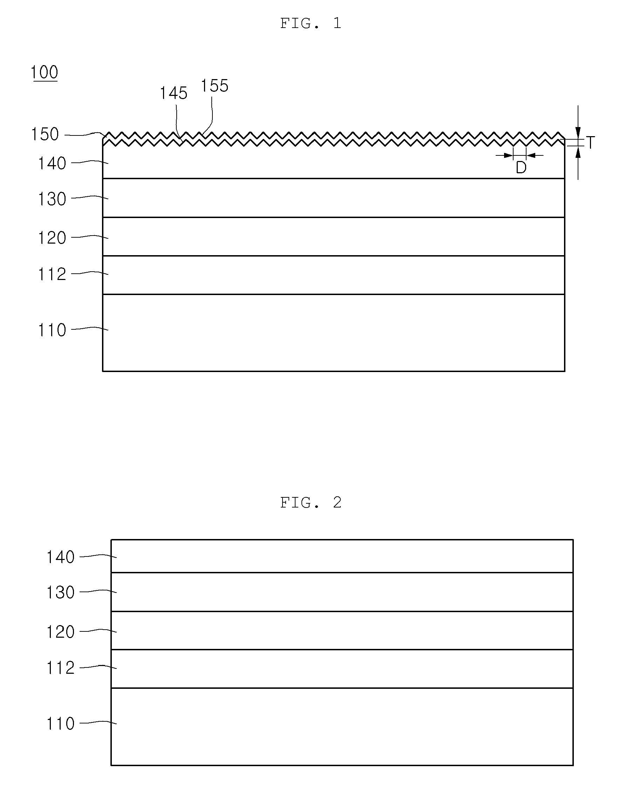

FIG. 1 is a side sectional view showing a semiconductor light emitting device according to the first embodiment.

Referring to FIG. 1, the semiconductor light emitting device 100 according to the embodiment includes a substrate 110, an undoped semiconductor layer 112, a first conductive semiconductor layer 120, an active layer 130, a second conductive semiconductor layer 140, and a transparent electrode layer 150.

The substrate 110 may include a transmittive substrate, such as a sapphire (Al₂0₃) substrate or a glass substrate. In addition, the substrate 110 can be selected from the group consisting of GaN, SiC, ZnO, Si, GaP, GaAs, and conductive substrates. A concave-convex pattern can be formed on the top surface of the substrate 110.

An undoped semiconductor layer 112 can be formed on the substrate 110. The undoped semiconductor layer 112 may include an undoped GaN layer. A buffer layer (not shown) can be interposed between the substrate 110 and the undoped semiconductor layer 112. The buffer layer may reduce difference in lattice constant between the substrate 110 and the undoped semiconductor layer 112. The buffer layer may be formed of at least one of GaN, InN, AIN, InGaN, AIGaN, InAIGaN, and AllnN. One of the buffer layer and the undoped semiconductor layer 112 may be omitted, or both buffer layer and undoped semiconductor layer 112 may be omitted.

The first conductive semiconductor layer 120 can be disposed on the undoped semiconductor layer 112. The first conductive semiconductor layer 120 may include an N type semiconductor layer doped with a first conductive dopant. The first conductive semiconductor layer 120 may include a compound semiconductor, such as GaN, InN, AlN, InGaN, AlGaN, InAlGaN, and AllnN. The first conductive dopant is an N type dopant selected from the group consisting of Si, Ge, Sn, Se, and Te.

The active layer 130 is disposed on the first conductive semiconductor layer 120. The active layer 130 may have a single quantum well structure or a multiple quantum well structure. For instance, the active layer 130 may have a single quantum well structure or a multiple quantum well structure including InGaN well/GaN barrier layers. The material of the quantum well layer and the quantum barrier layer of the active layer 130 may vary depending on the wavelength band of the light. A clad layer may be disposed on and/or under the active layer 130.

The second conductive semiconductor layer 140 is disposed on the active layer 130. The second semiconductor layer 140 may include a P type semiconductor layer doped with a second conductive dopant. For instance, the second conductive semiconductor layer 140 may include a compound semiconductor, such as GaN, InN, AIN, InGaN, AIGaN, InAlGaN or AllnN. The second conductive dopant is a P type dopant selected from Mg, Be and Zn.

The first conductive semiconductor layer 120, the active layer 130 and the second conductive semiconductor layer 140 may constitute the light emitting structure. An N type semiconductor layer can be additionally formed on the second conductive semiconductor layer 140. The light emitting structure may include at least one of an N-P junction structure, a P-N junction structure, an N-P-N junction structure, and a P-N-P junction structure.

A patterned roughness 145 can be formed on the top surface of the second conductive semiconductor layer 140. The patterned roughness 145 may have a nano-size. The patterned roughness 145 can be randomly formed. Due to the patterned roughness 145, the light emitted from the active layer or scattered light can be extracted to the outside without being subject to the total reflection even if the light is incident into the top surface of the second conductive semiconductor layer 140 with an incident angle above a critical angle. That is, the patterned roughness 145 varies the incident angle of the light so that the light can be extracted to the outside. On the assumption that the top surface of the second conductive semiconductor layer 140 is planarized, the critical angle refers to the maximum angle of the light that is emitted from the active layer 130 and then incident into the top surface of the semiconductor conductive semiconductor layer 130 so as to be extracted to the outside. That is, the critical angle refers to the total reflection angle at the boundary surface between two mediums having planarized surfaces. For instance, the critical angle between the sapphire layer and the GaN layer is about 46°, and the critical angle between the GaN layer and the ITO layer is about 53.13°.

The height T of the patterned roughness 145 is about 0.1 to 20nm, and the pitch D of the patterned roughness 145 is about 0.1 to 20nm. The patterned roughness 145 may have a conical shape or a random shape. For instance, the patterned roughness 145 may have a circular conical shape, a polygonal conical shape or a random conical shape.

The transparent electrode layer 150 can be formed on the second conductive semiconductor layer 140. The transparent electrode layer 150 may have a patterned roughness 155 corresponding to the patterned roughness 145 of the second conductive semiconductor layer 140.

For instance, the transparent electrode layer 150 may be formed of material selected from the group consisting of ITO (indium tin oxide), IZO (indium zinc oxide), IZTO (indium zinc tin oxide), IAZO (indium aluminum zinc oxide), IGZO (indium gallium zinc oxide), IGTO (indium gallium tin oxide), AZO (aluminum zinc oxide), ATO (antimony tin oxide), IrOx, RuOx, RuOx/ITO, Ni/IrOx/Au, and Ni/IrOx/Au/ITO. The embodiment may not limit the material for the transparent electrode layer 150.

FIGS. 2 to 6 are views showing the procedure for manufacturing the semiconductor light emitting device according to the first embodiment.

Referring to FIG. 2, the undoped semiconductor layer 112 is formed on the substrate 110. The first conductive semiconductor layer 120 is formed on the undoped semiconductor layer 112, and the active layer 120 is formed on the first conductive semiconductor layer 110. The second conductive semiconductor layer 130 is formed on the active layer 120.

The substrate 110 may include material selected from the group consisting of sapphire (Al₂0₃), GaN, SiC, ZnO, Si, GaP, GaAs, and GaAs. A concave-convex pattern can be formed on the top surface of the substrate 110, but the embodiment is not limited thereto.

A nitride semiconductor can be grown on the substrate 110. In this case, growth equipment may be selected from the group consisting of E-beam evaporator, PVD (physical vapor deposition), CVD (chemical vapor deposition), PLD (plasma laser deposition), dual-type thermal evaporator, sputtering, and MOCVD (metal organic chemical vapor deposition). However, the embodiment may not limit the growth equipment.

The undoped semiconductor layer 112 is formed on the substrate 110. The undoped semiconductor layer 112 may include an undoped GaN layer. A buffer layer (not shown) can be formed between the substrate 110 and the undoped semiconductor layer 112. One of the buffer layer and the undoped semiconductor layer 112 may be omitted, or both buffer layer and undoped semiconductor layer 112 may be omitted.

For instance, the first conductive semiconductor layer 120 is the N type semiconductor layer and the second conductive semiconductor layer is the P type semiconductor layer. The first conductive semiconductor layer 120 may include a compound semiconductor, such as GaN, InN, AIN, InGaN, AIGaN, InAlGaN, or AllnN, and is doped with an N type dopant, such as Si, Ge, Sn, Se, or Te. In addition, the second conductive semiconductor layer 140 may include a compound semiconductor, such as GaN, InN, AIN, InGaN, AlGaN, InAlGaN, or AlInN, and is doped with a P type dopant, such as Mg or Zn.

The first conductive semiconductor layer 120, the active layer 130 and the second conductive semiconductor layer 140 may constitute the light emitting structure, and another semiconductor layer can be formed on and/or under the light emitting structure. In addition, the light emitting structure may include at least one of an N-P junction structure, a P-N junction structure, an N-P-N junction structure, and a P-N-P junction structure.

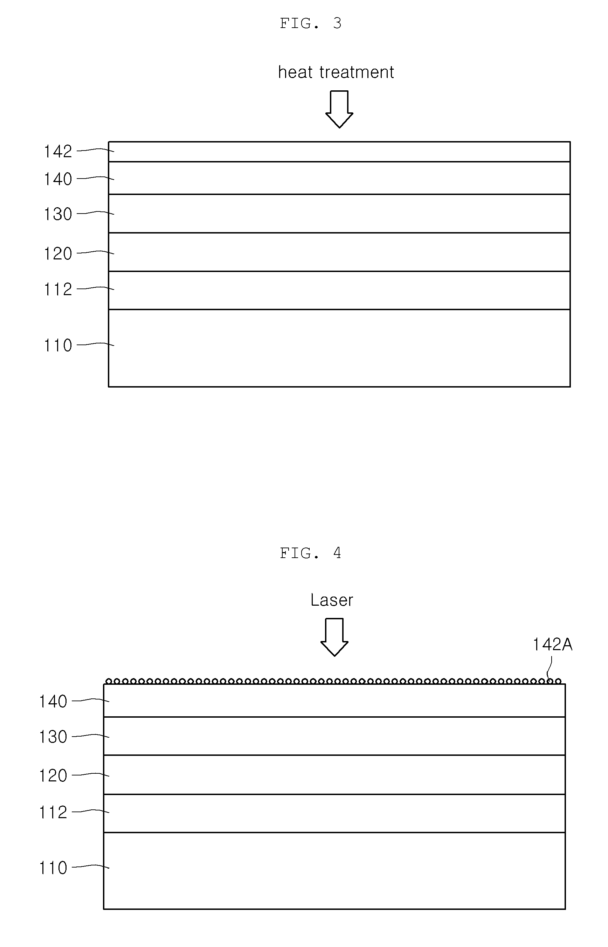

Referring to FIG. 3, a metal layer 142 is formed on the second conductive semiconductor layer 140. The metal layer 132 may be formed of one selected from the group consisting of Ni, Cr, Ag, Ti, Al, Pt, Au and alloy thereof, but the embodiment may not limit the material for the metal layer 132. The metal layer 142 has a thickness of about 1nm to 10µm, but the embodiment is not limited thereto.

Referring to FIGS. 3 and 4, the metal layer 142 is subject to the heat treatment process. The heat treatment process may vary depending on the metal material. In the case of Ag, the heat treatment process is performed at the temperature of 300∼500°C, and, in the case of Ni, the heat treatment process is performed at the temperature of 600∼900°C.

A metal dot layer 142A, as shown in FIG. 4, can be formed on the metal layer 142 through the heat treatment process. The metal dot layer 142A serves as a mask pattern of the second conductive semiconductor layer 140.

The size of the metal dot layer 142A serving as the metal mask pattern may vary depending on the metal material. In the case of Ag, the metal dot layer 142A has a thickness of about 100nm to 3um. In the case of Ni, the metal dot layer 142A has a thickness of about 1 nm to 20nm. The metal dot layer 142A is most effective when the metal dot layer 142A has a nano-size.

Referring to FIG. 4, when the metal dot layer 142A has been formed, the top surface of the second conductive semiconductor layer 140 is etched by irradiating laser onto the metal dot layer 142A. The laser may include excimer laser that does not cause damage to the semiconductor.

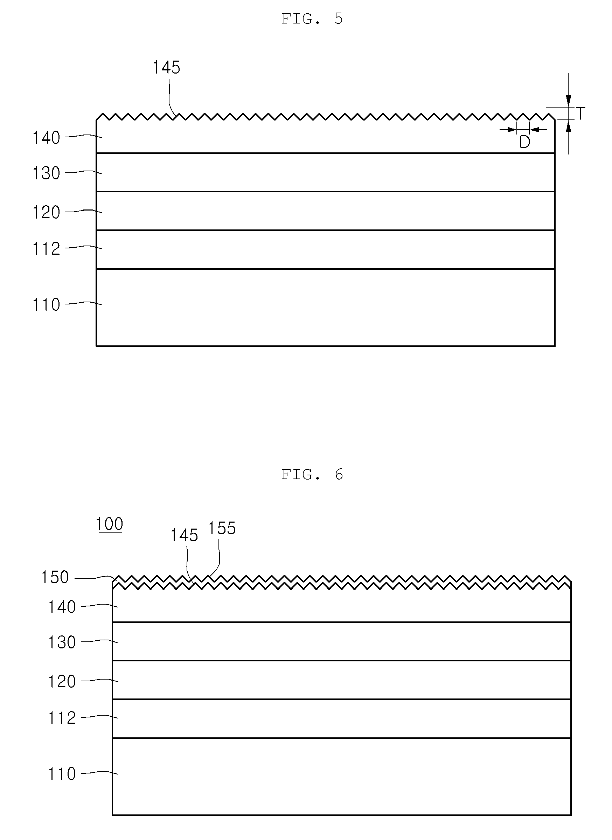

As the etching process has been performed by using the excimer laser, the metal dot layer 142A and the surface of the second conductive semiconductor layer 140, which is partially exposed, can be etched. When the metal dot layer 142A is etched, difference of etching depth may occur due to the material of the second conductive semiconductor layer 140. Therefore, as shown in FIG. 5, the patterned roughness 145 having a nano-size is formed on the surface of the second conductive semiconductor layer 140.

That is, the patterned roughness 145 having the nano-size is formed on the surface of the second conductive semiconductor layer 140. The remaining metal dot layer 142A can be removed through the etching process.

The patterned roughness 145 has the height T and the pitch D of about 0.1∼20nm. The patterned roughness 145 has a circular conical shape, a polygonal conical shape, a random conical shape or a random shape.

Referring to FIG. 6, the transparent electrode layer 150 is formed on the second conductive semiconductor layer 140. The transparent electrode layer 150 may be formed of at least one selected from the group consisting of ITO (indium tin oxide), IZO (indium zinc oxide), IZTO (indium zinc tin oxide), IAZO (indium aluminum zinc oxide), IGZO (indium gallium zinc oxide), IGTO (indium gallium tin oxide), AZO (aluminum zinc oxide), ATO (antimony tin oxide), IrOx, RuOx, RuOx/ITO, Ni/IrOx/Au, and Ni/IrOx/Au/ITO. The embodiment may not limit the material for the transparent electrode layer 150.

The patterned roughness 155 corresponding to the patterned roughness 145 of the second conductive semiconductor layer 140 can be formed on the transparent electrode layer 150.

According to the embodiment, the first electrode is formed on the first conductive semiconductor layer 120 and the second electrode having a predetermined pattern is formed on the second conductive semiconductor layer 140 and/or the transparent electrode layer 150 through the mesa etching process.

In such a semiconductor light emitting device, the light emitted from the active layer 130 or scattered light can be incident into the patterned roughness 145 of the second conductive semiconductor layer 140. That is, due to the patterned roughness 145 of the second conductive semiconductor layer 140, the light emitted from the active layer 130 or scattered light can be extracted to the outside without being subject to the total reflection even if the light is incident into the top surface of the second conductive semiconductor layer 140 with an incident angle above a critical angle. That is, the patterned roughness 145 varies the incident angle of the light so that the light can be extracted to the outside. On the assumption that the top surface of the second conductive semiconductor layer 140 is planarized, the critical angle refers to the maximum angle of the light that is emitted from the active layer 130 and then incident into the top surface of the semiconductor conductive semiconductor layer 130 so as to be extracted to the outside. That is, the critical angle refers to the total reflection angle at the boundary surface between two mediums having planarized surfaces. For instance, the critical angle between the sapphire layer and the GaN layer is about 46°, and the critical angle between the GaN layer and the ITO layer is about 53.13°.

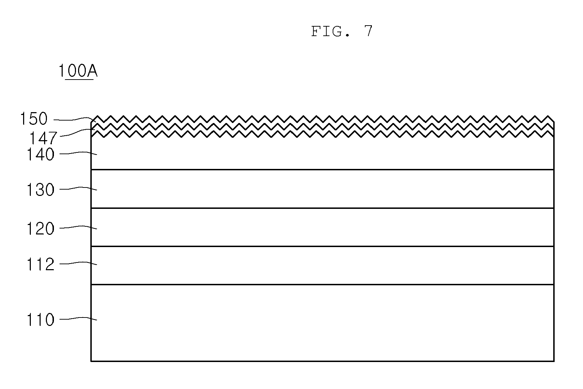

FIG. 7 is a sectional view showing a semiconductor light emitting device according to the second embodiment.

Referring to FIG 7, the semiconductor light emitting device 100A according to the second embodiment includes an undoped semiconductor layer 112, a first conductive semiconductor layer 120, an active layer 130, a second conductive semiconductor layer 140, a third conductive semiconductor layer 147 and a transparent electrode layer 150.

The third conductive semiconductor layer 147 is formed on the second conductive semiconductor layer 140 and includes at least one semiconductor layer doped with a first conductive dopant. For instance, the third conductive semiconductor layer 147 includes at least one selected from the group consisting of GaN, InN, AIN, InGaN, AIGaN, InAIGaN, and AllnN. The first conductive dopant may include an N type dopant.

If the first conductive semiconductor layer 120 is the N type semiconductor layer, the third conductive semiconductor layer 147 is the N type semiconductor layer. In contrast, if the first conductive semiconductor layer 120 is the P type semiconductor layer, the third conductive semiconductor layer 147 is the P type semiconductor layer.

The transparent electrode layer 150 is formed on the third conductive semiconductor layer 147. The transparent electrode layer 150 may diffuse input current in uniform distribution.

The patterned roughness 145, 148 and 155 having the nano-size are formed on the second conductive semiconductor layer 140, the third conductive semiconductor layer 147 and the transparent electrode layer 150, so that the patterned roughness having the nano-size is constructed in a triple structure. The patterned roughness having the nano-size can improve the light extracting efficiency.

Although embodiments have been described with reference to a number of illustrative embodiments thereof, it should be understood that numerous other modifications and embodiments can be devised by those skilled in the art that will fall within this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

The embodiment is applicable in the light emitting device for supplying the light.

## Claims

1. A semiconductor light emitting device (100) comprising:
a first conductive semiconductor layer (120);
an active layer (130) on the first conductive semiconductor layer; and
a second conductive semiconductor layer (140) on the active layer, in which a patterned roughness (145) is formed on a top surface of the second conductive semiconductor layer.

2. The semiconductor light emitting device of claim 1, wherein the height (T) of the patterned roughness (145) is comprised between 0.1 and 20nm and the patterned roughness has for example a pitch (D) of 0.1 to 20nm.

3. The semiconductor light emitting device of claim 1 or of claim 2, further comprising a third conductive semiconductor layer (147) disposed on the second conductive semiconductor layer (140) along the patterned roughness.

4. The semiconductor light emitting device of any of preceding claims, further comprising a transparent electrode layer (150) disposed on the second conductive semiconductor layer (140) along the patterned roughness.

5. The semiconductor light emitting device of claim 4, wherein the material of the transparent electrode layer (150) comprises at least a material chosen within the group consisting of ITO (indium tin oxide), IZO (indium zinc oxide), IZTO (indium zinc tin oxide), IAZO (indium aluminum zinc oxide), IGZO (indium gallium zinc oxide), IGTO(indium gallium tin oxide), AZO (aluminum zinc oxide), ATO (antimony tin oxide), IrOx, RuOx, RuOx/ITO, Ni/IrOx/Au, and Ni/IrOx/Au/ITO.

6. The semiconductor light emitting device of any of preceding claims, wherein the patterned roughness comprises a conical shape.

7. A method of manufacturing a semiconductor light emitting device (100), the method comprising:
depositing a first conductive semiconductor layer (120), an active layer (130), and a second conductive semiconductor layer (140);
forming a metal layer (142) on the second conductive semiconductor layer;
forming a metal dot layer (142 A) by a heat treatment to the metal layer; and
etching the metal dot layer to form a patterned roughness (145) having a nano-size on a surface of the second conductive semiconductor layer (140).

8. The method of claim 7, wherein the etching the metal dot layer (142A) is performed by irradiating a laser.

9. The method of claim 8, wherein the laser includes excimer laser.

10. The method of any of claims 7 to 9, wherein the material of the metal layer comprises at least a material chosen within the group consisting of Ni, Cr, Ag, Ti, Al, Pt, Au, and an alloy thereof.

11. The method of any of claims 7 to 10, wherein the height (T) of the patterned roughness (145) is comprised between 0.1 and 20nm and the patterned roughness has for example a pitch (D) of 0.1 to 20nm.

12. The method of any of claims 7 to 11, further comprising forming a third conductive semiconductor layer (147) on the second conductive semiconductor layer (140) along the patterned roughness.

13. The method of any of claims 7 to 12, further comprising forming a transparent electrode layer (150) on the second conductive semiconductor layer (140) along the patterned roughness.

14. The method of claim 13, wherein the material of the transparent electrode layer comprises at least a material chosen within the group consisting of ITO (indium tin oxide), IZO (indium zinc oxide), IZTO (indium zinc tin oxide), IAZO (indium aluminum zinc oxide), IGZO (indium gallium zinc oxide), IGTO(indium gallium tin oxide), AZO (aluminum zinc oxide), ATO (antimony tin oxide), IrOx, RuOx, RuOx/ITO, Ni/IrOx/Au, and Ni/IrOx/Au/ITO.

15. The method of any of claims 7 to 14, wherein the patterned roughness comprises a conical shape.
